# DEMANDE DE BREVET EUROPEEN

(11) **EP 1 220 594 A1**
(43) Date de publication de la demande: **03.07.2002**
(21) Numéro de dépôt: 01203718.0
(22) Date de dépôt: 01.10.2001
(51) Int. Cl.: H05K 9/00, H04N 7/00

(54) **Appareil électrique comportant un blindage et des moyens de transmission avec filtrage d'un signal électrique d'un côté à l'autre du blindage**

(30) Priorité: 03.10.2000 FR 0012616
(71) Demandeur: Koninklijke Philips Electronics N.V., 5621 BA Eindhoven (NL)
(72) Inventeur: Delvart, Bernard, 75008 Paris (FR)
(74) Mandataire: de la Fouchardière, Marie-Noelle

(57) **Abrégé**

L'invention concerne un appareil électrique qui comporte un boîtier métallique constitué d'au moins une partie contenant une alimentation à découpage, une partie contenant un amplificateur, et un blindage séparant ces deux parties. Des ouvertures sont prévues dans le blindage pour transmettre des signaux de la première vers la seconde partie, en les filtrant. Pour cela un dispositif de filtrage est prévu. Ce dispositif est constitué par un circuit imprimé comportant au moins une entrée/sortie, une capacité à montage de surface, une masse et des moyens de connexion de la masse au blindage.

Application : réseau câblé de distribution de signaux TV.

## Description

### Domaine de l'invention

L'invention concerne un appareil électrique comportant un boîtier constitué d'au moins une première partie contenant une alimentation à découpage, une seconde partie contenant un circuit de traitement, et un blindage pour isoler lesdites première et seconde parties, ledit blindage étant doté d'au moins une ouverture au niveau de laquelle est fixée un dispositif de filtrage.

L'invention concerne également un réseau de distribution câblée comportant au moins un appareil électrique de ce type.

L'invention s'applique notamment aux amplificateurs utilisés dans les systèmes câblés de distribution de signaux de télévision.

### Arrière plan technologique de l'invention

La société TONNA, par exemple, commercialise un tel appareil sous la référence 945331. Dans cet appareil, le dispositif de filtrage comporte un condensateur circulaire, traversé par un fil et monté sur un support métallique qui est lui-même fixé au blindage.

De tels condensateurs circulaires sont par exemple commercialisés par la société californienne INSTEC sous les références P/N610-103A1 et P/N640-103B.

Ils présentent l'inconvénient d'être chers et encombrants lorsque leur capacité d'atténuation est élevée. Pour cette raison la capacité des condensateurs circulaires utilisés est en général limitée à 10nF.

Une telle atténuation n'est pas toujours suffisante. En particulier, elle n'est pas suffisante pour filtrer des tensions délivrées en sortie de l'alimentation à découpage. Un circuit de filtrage préliminaire est donc prévu, au niveau de l'alimentation à découpage, pour limiter les parasites sur les tensions d'alimentation délivrées en sortie de l'alimentation à découpage. Le condensateur circulaire placé au niveau du blindage n'a alors pour fonction que d'atténuer les parasites rayonnés au niveau de l'alimentation, qui sont récoltés par le fil reliant l'alimentation à découpage au circuit de traitement.

L'invention a notamment pour but de proposer un dispositif de filtrage ayant une capacité d'atténuation élevée, dont le coût et l'encombrement sont limités.

### Résumé de l'invention

Un appareil électrique selon l'invention et tel que décrit dans le paragraphe introductif est caractérisé en ce que ledit dispositif de filtrage est constitué par un circuit imprimé qui comporte :
- des moyens de connexion pour recevoir un signal en provenance de ladite première partie, et pour délivrer un signal filtré à ladite seconde partie,
- au moins une masse,
- au moins une capacité du type à montage de surface, montée entre lesdits moyens de connexion et la masse,
- des moyens de mise en contact de la masse et du blindage.

L'invention permet ainsi d'obtenir des capacités de fortes valeurs pour un coût et un encombrement réduits. Puisqu'il est possible d'utiliser de fortes capacités d'atténuation, il n'est plus nécessaire de prévoir un filtrage préliminaire au niveau de l'alimentation à découpage.

A titre d'exemple, un condensateur circulaire tel qu'utilisé dans l'art antérieur, qui fonctionne à une tension de 50V, et qui a une valeur de 10 nF coûte environ 2 euro. Un condensateur circulaire du même type ayant une valeur de 1µF coûte environ 15 euro. Sur un circuit imprimé de 25mm sur 15mm il est possible de réaliser plusieurs filtres, pour filtrer plusieurs signaux, en utilisant des capacités à montage de surface d'une valeur de l'ordre de 1µF ou plus, pour un coût global d'environ 1,5 euro.

L'un des avantages de l'invention est donc de permettre de multiplier le nombre de signaux filtrés sans que cela augmente le coût du dispositif de façon significative.

De plus, les condensateurs circulaires actuellement disponibles dans le commerce ont une valeur maximum de 1µF. L'invention permet d'obtenir des valeurs bien supérieures (de l'ordre de 100µF).

Dans un mode de réalisation particulièrement efficace, ledit circuit imprimé est un circuit double face à trous métallisés, la ou les capacités étant montées sur l'une des faces, et la ou les masses étant montées sur l'autre face. Le circuit imprimé est par exemple plaqué sur le blindage par une ou plusieurs lames à ressort de façon à ce que la ou les masses soient en contact avec le blindage.

### Brève description des dessins

L'invention sera mieux comprise et d'autres détails apparaîtront dans la description qui va suivre, en regard des dessins annexés donnés à titre d'exemples non limitatifs et dans lesquels :
- la figure 1 est un schéma d'un exemple d'appareil électrique selon l'invention,
- la figure 2 est un schéma électrique d'un exemple de dispositif de filtrage selon l'invention,
- la figure 3 est un schéma mécanique d'un exemple de dispositif de filtrage selon l'invention,
- la figure 4 est un exemple de réseau de distribution câblé selon l'invention.

### Description d'un mode de réalisation préférentiel de l'invention

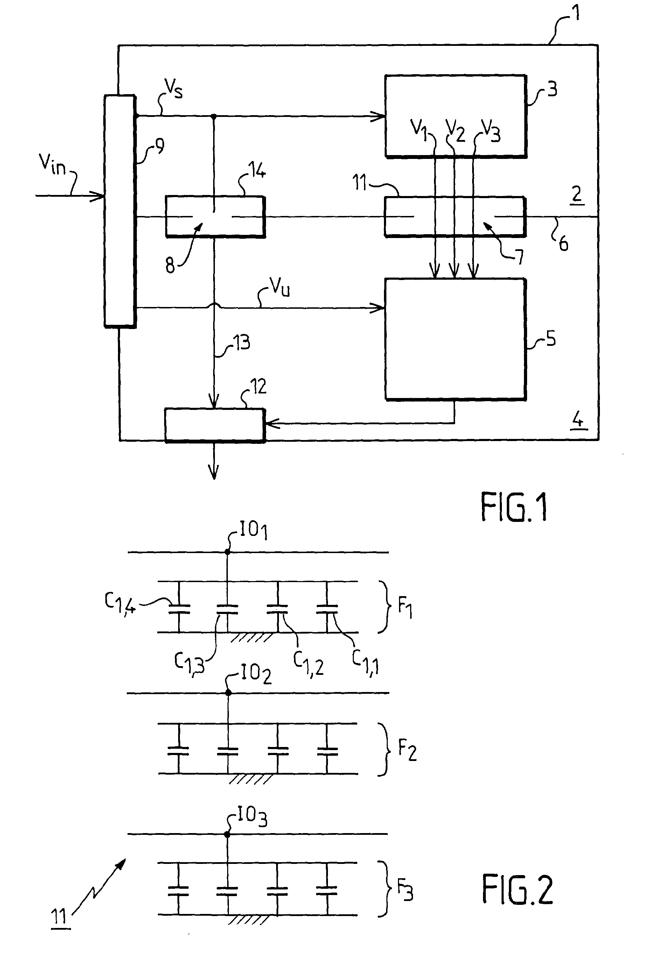

Sur la figure 1, on a représenté un exemple d'appareil électrique selon l'invention. Cet appareil comporte un boîtier métallique 1 qui contient dans une première partie 2 une alimentation à découpage 3, et dans une seconde partie 4 un circuit de traitement 5 qui dans cet exemple de réalisation est un amplificateur. Les première et seconde parties 2 et 4 sont isolées l'une de l'autre par un blindage 6. Deux ouvertures 7 et 8 sont pratiquées dans le blindage 6.

L'appareil reçoit en entrée un signal Vᵢₙ qui est une combinaison d'un signal de téléalimentation Vₛ à 50Hz, et d'un signal utile Vᵤ contenu dans la bande 5Mhz-1GHz. Ces deux signaux sont séparés par filtrage au niveau de l'entrée 9 de l'appareil. Le signal utile Vᵤ est transmis à l'amplificateur 5. Le signal de téléalimentation Vₛ est transmis à l'alimentation à découpage 3.

Dans l'exemple décrit ici, l'alimentation à découpage 3 délivre trois tensions continues V₁ à V₃ de 24V, 12V et 5V respectivement, à partir du signal de téléalimentation qui est une tension alternative de 48V.

L'alimentation à découpage 3 crée des résidus de découpage qui ont des harmoniques jusqu'aux fréquences de travail de l'amplificateur 5. Un premier dispositif de filtrage 11 est fixé au blindage 6 au niveau de la première ouverture 7 pour filtrer les résidus contenus dans ces trois tensions V₁ à V₃.

Par ailleurs le signal de téléalimentation de l'appareil Vₛ est redirigé sur une sortie 12 de l'appareil par un câble 13 qui traverse les parties 2 et 4 du boîtier 1 en passant par la seconde ouverture 8. Un second dispositif de filtrage 14 est fixé au niveau de cette seconde ouverture 8 pour filtrer les parasites rayonnés par l'alimentation à découpage 3 et récoltés par le câble 13.

Le signal utile Vᵤ est amplifié par l'amplificateur 5. Et le signal amplifié est combiné, par filtrage, avec le signal de téléalimentation Vₛ, au niveau de la sortie 12.

Sur la figure 2 on a représenté un schéma électrique du dispositif de filtrage 11. D'après la figure 2, le dispositif de filtrage 11 comporte :
- trois entrées/sorties IO₁ à IO₃ qui reçoivent chacune une tension d'alimentation fournie par l'alimentation à découpage 3, et qui délivrent chacune à l'amplificateur 5 une tension filtrée,
- trois filtres F₁ à F₃ montés entre ces trois entrées/sorties IO₁ à IO₃ et la masse pour filtrer les trois tensions d'alimentation fournies par l'alimentation à découpage 3.

Dans cet exemple de réalisation, chaque filtre Fᵢ est constitué par quatre capacités C_{i,1} à C_{i,4} montées en parallèle entre la masse d'une part et une entrée/sortie IOᵢ du dispositif d'autre part. Ces quatre capacités ont par exemple une valeur de 1µF chacune. On utilise par exemple des capacités 222293416651 fabriquées par la société Philips.

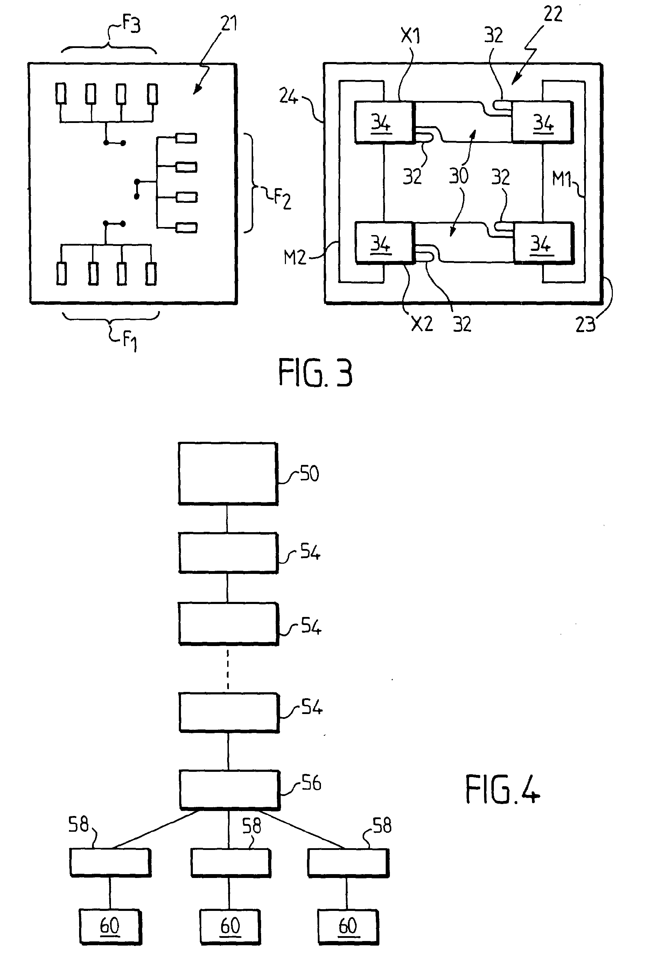

Sur la figure 3 on a représenté un schéma mécanique d'un dispositif de filtrage 11 selon l'invention. D'après la figure 3, le dispositif de filtrage 11 comporte un circuit imprimé 20 qui est un circuit double face à trous métallisés.

Dans cet exemple de réalisation, le circuit 20 a une forme rectangulaire. Des capacités à montage de surface sont montées sur une première face 21 du circuit imprimé 20 de façon à constituer les trois filtres F₁ à F₃. Deux plans de masse M1 et M2 sont placés sur une seconde face 22 du circuit 20, le long de deux côtés parallèles 23 et 24 du circuit 20. Deux lames à ressort métalliques X1 et X2 sont également montées sur cette seconde face, le long des deux autres côtés 25 et 26 du circuit 20. Ces lames à ressort comportent une partie centrale 30, plate, dotée de deux pieds 32 qui s'insèrent dans le circuit imprimé, et deux parties latérales 34 en forme de pinces qui viennent plaquer les parois du blindage 6 au niveau de l'ouverture 7 sur les plans de masse M1 et M2.

Le dispositif de filtrage 13 qui est fixé au niveau de l'ouverture 8 est similaire au dispositif de filtrage 11 qui vient d'être décrit. Mais il ne comporte qu'un seul filtre. Ce filtre est par exemple constitué de cinq capacités montées en parallèle ayant chacune une valeur de 120nF. On utilise par exemple des capacités 222291119863 fabriquées par la société Philips .

Sur la figure 4 on a représenté un exemple de réseau de distribution câblé selon l'invention. Ce réseau comporte une tête de réseau 50, un câble de transmission 52, des amplificateurs 54 tels que décrits plus haut, placés sur le câble à des distances régulières et dont la fonction est de compenser l'atténuation du signal utile due au transport sur le câble, des répartiteurs 56, et au niveau de chaque destinataire, une boîte d'arrivée 58 connectée à un récepteur de télévision 60.

L'invention n'est pas limitée au mode de réalisation qui vient d'être décrit à titre d'exemple. En particulier, l'utilisation d'un circuit double face à trous métallisés est particulièrement intéressante parce qu'elle permet de réduire l'encombrement du circuit et de simplifier sa fabrication. Toutefois il est possible d'utiliser un circuit à une seule face, en plaçant les capacités à montage de surface du même côté que la masse.

De même, les lames à ressort ne sont pas les seuls moyens de fixation susceptibles d'être utilisés pour fixer le circuit imprimé 20 sur le blindage 3. Par exemple on peut utiliser des vis, des rivets...

L'utilisation de moyens de fixation métalliques présente les avantages suivants :
- bonne tenue en température,
- facilité de montage (montage par soudure sur le circuit imprimé),
- amélioration du contact électrique.
Il est toutefois possible d'utiliser des moyens de fixation qui ne sont pas métalliques, par exemple des moyens de fixation en matière plastique.

## Revendications

1. Appareil électrique comportant un boîtier (1) constitué d'au moins une première partie (2) contenant une alimentation à découpage (3), une seconde partie (4) contenant un circuit de traitement (5), et un blindage (6) pour isoler lesdites première et seconde parties, ledit blindage étant doté d'au moins une ouverture (7, 8) au niveau de laquelle est fixée un dispositif de filtrage (11, 14), **caractérisé en ce que** ledit dispositif de filtrage est constitué par un circuit imprimé qui comporte :
- des moyens de connexion (IO₁ à IO₃) pour recevoir un signal en provenance de ladite première partie, et pour délivrer un signal filtré à ladite seconde partie,
- au moins une masse (M1, M2),
- au moins une capacité du type à montage de surface (C_{i,1} à C_{i,4}), montée entre lesdits moyens de connexion et la masse,
- des moyens (X1, X2) de mise en contact de la masse et du blindage.

2. Appareil selon la revendication 1, **caractérisé en ce que** ledit circuit imprimé est un circuit double face à trous métallisés, la ou les capacités étant montées sur l'une des faces, et la ou les masses étant montées sur l'autre face.

3. Appareil selon la revendication 1, **caractérisé en ce que** le dispositif de filtrage est fixé audit blindage par au moins une lame à ressort.

4. Réseau de distribution câblé comportant au moins appareil électrique selon la revendication 1.
